# EUROPEAN PATENT SPECIFICATION

(11) **EP 1 554 812 B1**
(45) Date of publication and mention of the grant of the patent: **06.12.2006**
(21) Application number: 03808793.8
(22) Date of filing: 19.09.2003
(51) Int. Cl.: H03M 13/35, H04L 1/00, H04L 29/06

(54) **SYSTEM AND METHOD FOR PROVIDING ERROR RECOVERY FOR STREAMING FGS ENCODED VIDEO OVER AN IP NETWORK**
SYSTEM UND VERFAHREN ZUR BEREITSTELLUNG VON FEHLERBEHEBUNG FÜR STREAMING-FGS-CODIERTE VIDEOSIGNALE ÜBER EIN IP-NETZWERK
SYSTEME ET PROCÉDÉ DE RECOUVREMENT D'ERREUR POUR LA DIFFUSION EN CONTINU DE DONNEES VIDEO FGS CODEES DANS UN RÉSEAU INTERNET

(30) Priority: 15.10.2002 US 418634 P; 01.05.2003 US 467040 P
(43) Date of publication of application: 20.07.2005
(73) Proprietor: Koninklijke Philips Electronics N.V., 5621 BA Eindhoven (NL)
(72) Inventor: LI, Qiong, Briarcliff Manor, NY 10510-8001 (US); VAN DER SCHAAR, Mihaela, Briarcliff Manor, NY 10510-8001 (US); CHEN, Richard, Briarcliff Manor, NY 10510-8001 (US)
(74) Representative: Groenendaal, Antonius W. M.
(86) International application number: PCT/IB2003/004174
(87) International publication number: WO 2004/036760

(56) References cited:
- WO-A-02/09436
- WO-A-97/33402
- US-A- 4 701 923
- WENJUN ZANG ET AL: "3G wireless multimedia: technologies and practical issues" PROCEEDINGS 2002 INTERNATIONAL CONFERENCE ON IMAGE PROCESSING. ICIP 2002. ROCHESTER, NY, SEPT. 22 - 25, 2002, INTERNATIONAL CONFERENCE ON IMAGE PROCESSING, NEW YORK, NY: IEEE, US, vol. 2 OF 3, 22 September 2002 (2002-09-22), pages 5-8, XP010607246 ISBN: 0-7803-7622-6
- "PacketVideo multimedia technology overview passage" PACKETVIDEO MULTIMEDIA TECHNOLOGY OVERVIEW, XX, XX, February 2002 (2002-02), pages 1-16, XP002968316

## Description

The present claimed invention relates to the field of streaming media data, particularly scalably encoded data. More specifically, the present claimed invention relates to the protection of such data.

Video transmission or video streaming within communication networks, such as ISDN networks or the Internet has become an important application of such communications networks. In the future, packet oriented mobile networks like GPRS (General Packet Radio Service) and UMTS (Universal Mobile Telecommunications Standard/System) will be commonly used to connect mobile users to fixed communication networks like the above-mentioned ISDN networks or the Internet. It is therefore important to employ efficient and intelligent support of high quality video streaming into wireless radio networks.

The problem of error concealment in video communications is becoming increasingly important because of the growing interest in the delivery of compressed video over wireless channels. Several packet-oriented transmission modes have been proposed for next generation wireless standards like EGPRS (Enhanced General Packet Radio Service) or UMTS, which are mostly based on the same principle: Long message blocks, typically IP packets that enter the wireless part of the network, are split up into segments of desired length, which can be multiplexed onto link layer packets of fixed size. The packets are then transmitted sequentially over the wireless link, reassembled, and passed on to the next network element. However, compared to the rather benign channel characteristics of present day fixed or wire line networks, wireless links suffer from severe fading, noise, and interference conditions in general, thus resulting in a relatively high residual bit error rate after detection and decoding.

Two types of error-recovery methods are commonly used to support video streaming over both wired and wireless networks: retransmission and forward-error correction (FEC). FEC coding is a well-known technique for achieving error correction and detection in data communications. FEC has the disadvantage of increasing transmission overhead and hence reducing usable bandwidth for the payload data. Thus it is generally used judiciously in video services, since video services are very demanding in bandwidth but can tolerate a certain degree of loss. The retransmission method has the advantage of high bandwidth utilization, but suffers from long recovery delays which may not be tolerable for applications having strict delay constraints.

In the past, there has been a distinct line between utilizing one or the other method. An application design chooses either retransmission or FEC. However, IP based networks, are heterogeneous and evolving. It is conceivable that applications could operate in completely different network environments, making the network conditions hard to predict. This situation makes it difficult to choose the right error-recovery method for all possible operating scenarios.

An ideal solution for error-recovery would be to combine retransmission and FEC to thereby allow an application to dynamically choose one or the other, or rather combine them in real-time according to perceived network conditions.

Hybrid ARQ and adaptive FEC are two methods which combine the strengths of retransmission and FEC. In hybrid ARQ, the video data is pre-encoded by some FEC coding scheme, such as a Reed-Solomon coding scheme, and then the sender and receiver use a specially designed ARQ-like protocol to perform the protection. In adaptive FEC, FEC data is separated from original media streams, and "join"/"leave" commands are employed to achieve adaptive protection. However, adaptive FEC is limited in two ways. First, it uses Internet Group Management Protocol (IGMP) to signal the join/leave action, which may introduce a very long latency in the signaling process that eventually defeat the protection purpose, such as retransmission. Second, while it emphasizes the FEC coding algorithm, it lacks an architecture and protocols to carry out the goals of adaptive FEC.

WO 97/33402-A1 discloses a system for transmitting a data stream across a network, where a protection bitstream is produced from the data stream using a channel coding technique.

It would be an advance in the art to provide a realistic architecture that specifies the protocols that are necessary for carrying out adaptive and efficient protection, thereby allowing applications to switch between different protection strategies dynamically.

In accordance with certain aspects of the present invention, methods and systems are provided which allow a receiving device (client) to dynamically elect to receive protection data and determine the type of protection data to be received.

For example, in accordance with certain exemplary implementations of the present invention, a method is provided for use in a server and a corresponding receiving device in communication with the server. The method includes the acts of: a first coding act for producing an encoded base layer from the bit stream using a frame prediction coding technique; a second coding act for producing an encoded enhancement layer from the bit stream using a fine granular scalable (FGS) coding technique; a first generating act for generating at least one protection bit stream; a second generating act for generating a first base layer hinting bit stream; a third generating act for generating a first enhancement layer hinting bit stream; and a fourth generating act for generating a first protection hinting bit stream.

According to another aspect, the present invention is a system that includes: means for producing an encoded base layer from the bit stream using a frame prediction coding technique; means for producing an encoded enhancement layer from the bit stream using a fine granular scalable (FGS) coding technique; means for generating at least one protection bit stream; means for generating a first base layer hinting bit stream; means for generating a first enhancement layer hinting bit stream; and means for generating a first protection hinting bit stream.

The proposed error protection method and system referred to herein as on-demand protection, provides a number of advantages over the prior art, including: (1) The method may be advantageously fitted into an overall FGS streaming architecture; (2) The method supports both multicast and unicast applications; (3) The method takes full advantage of the MPEG-4 file format, thereby allowing a general-purpose MPEG-4 server to perform adaptive error protection to streaming applications; (4) Protection data is separated from protected data. In this manner, changing the protection data can change the protection level or strategy, but the protection procedures remain the same; (5) The method allows applications to dynamically choose between retransmission-like protection or FEC-like protection or hybrid ARQ, thereby gaining better protection performance; (6) The method uses Real-time Transport protocol (RTSP) instead of Internet Group Management protocol (IGMP) which can achieve faster protection and provide more flexibility to applications.

The invention is defined in independent method claim 1 and independent system claim 11.

Referring now to the drawings where like reference numbers represent corresponding parts throughout:
FIG. 1 illustrates an exemplary network for performing end-to-end transmission of streaming media in which the present invention may be embodied; and
FIG. 2 illustrates, by way of example, an architecture and associated protocols for implementing the protection scheme of the invention.

The following terms are defined to better understand the present invention:
Streaming media - essentially mean real-time or near-real-time delivery of critical content (e.g., audio and/or video data) to a subscribing user's client device or devices. The client device/devices render the streamed media in a way that is appropriate for the client device and the media.
RTP protocol - It is used as the standard real time-based packetization-method in many environments and sits just above transport layers in a protocol stack, such as UDP (User Datagram Protocol)/IP(Internet Protocol). Generally, RTP is a transport protocol for real time data, and provides a timestamp, sequence number, data loss detection, security, content identification, and other data relevant to real time data delivery. RTP can be used in a unicast or multicast context.
RTSP protocol - an application-level protocol, which stands for Real Time Session Protocol, has been also developed to offer session negotiation and content description mechanism. RTSP describes how to stream the content from a server to a client. Streaming comprises breaking content into packets having sizes amenable (with respect to intermediate network characteristics) to transmission between the server and client.
FEC - Forward error correction is a well-known error correction technique which provides a mechanism by which a sending device provides a receiving device with additional FEC data that can be subsequently used by the receiving device to detect and correct errors in received data. Thus, to support FEC the sending device typically includes an FEC encoder and the receiving device typically includes an FEC decoder. FEC allows for different levels of encoding. The different levels of encoding can be expressed by a density ratio based on the amount of FEC data generated for a given amount of data. Thus, for example, in certain systems the FEC encoding level may be "high" when there is a ratio of one FEC packet for every data packet. In other systems, the FEC encoding level may be "lower" such that there is a ratio of on FEC packet to every four data packets.

In the following description, for purposes of explanation rather than limitation, specific details are set forth such as the particular architecture, interfaces, techniques, etc., in order to provide a thorough understanding of the present invention. For purposes of simplicity and clarity, detailed descriptions of well-known devices, circuits, and methods are omitted so as not to obscure the description of the present invention with unnecessary detail.

It is assumed herein that the Real-time Transport Protocol (RTP) and the Real Time Streaming Protocol (RTSP) underlie delivery of content to the client, since these protocols are well known. It will be appreciated by one skilled in the art that these protocols are discussed herein for exemplary purposes only due to their broad familiarity by artisans and that any protocol providing the signaling characteristics relied upon herein, may be used.

In one aspect, the present invention relates to a system and associated methods for providing at least one media data protection stream, independent of an associated media data stream, and further providing at least one media data hint track to facilitate the transmission of the media data stream over a network and at least one protection data stream to facilitate the transmission of the at least one media data protection stream across the network.

In a related aspect, the present invention is directed to a system and associated methods for allowing an application the freedom to dynamically choose an error protection scheme on demand.

Although the following is addressed in particular to MPEG-4 FGS, it will be clear to a person skilled in the art that the invention can be advantageously applied to any scalable coding scheme.

The principles and operation of method and a system for providing an error-protection scheme over an IP network may be better understood with reference to the drawings and the accompanying description.

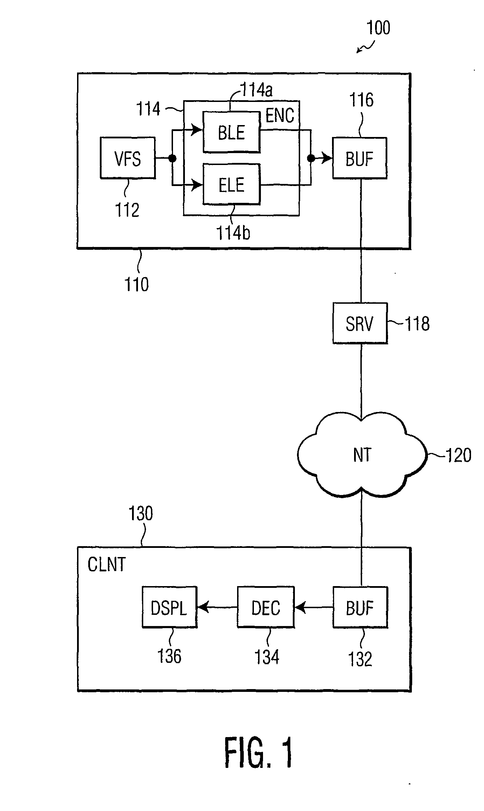

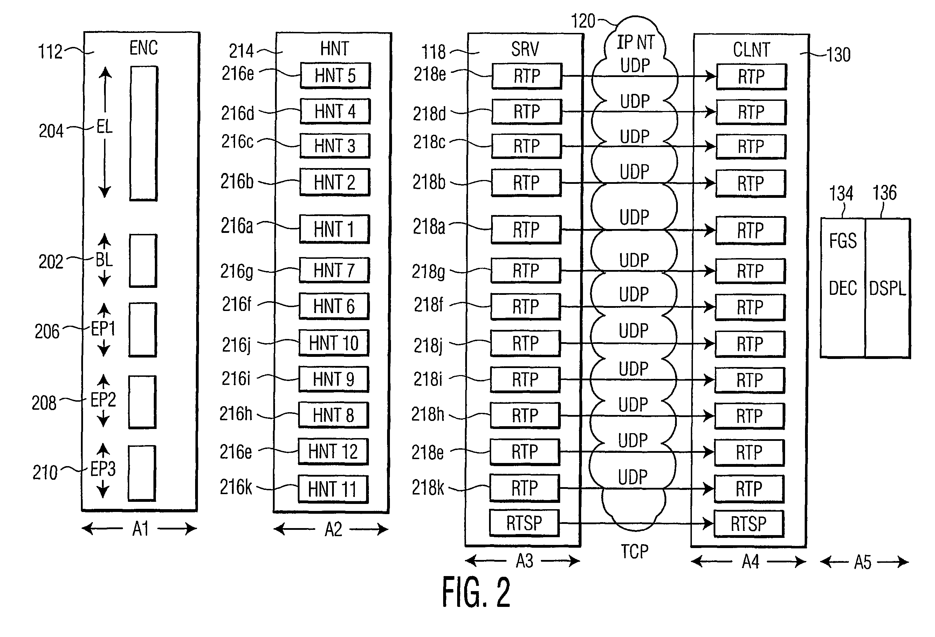

FIGS. 1 and 2, discussed below, and the various embodiments used to describe the principles of the present invention in this patent document are by way of illustration only and should not be construed in any way to limit the scope of the invention. Those skilled in the art will understand that the principles of the present invention may be implemented in any suitably arranged video encoder and decoder.

The present invention provides a novel architecture and specific protocols to provide a capability for providing an adaptive and efficient error protection scheme, for use in a network, such as the one shown in Fig. 1, thereby allowing applications to switch between different error protection strategies dynamically, as will be described.

FIG. 1 illustrates a simplified representation of one embodiment of a system 100 incorporating the invention. As shown, a client 130 and a server 118 are in communication over a network 120. Exemplary system 100 is only one example of a suitable system and is not intended to suggest any limitation as to the scope of use or functionality of the improved methods and apparatuses described herein.

For purposes of illustration, the following description will assume that an audio or video signal has been converted into a digital data stream (a media stream) and is to be transmitted in a network from a source node 110, via a server 118, to a destination node (i.e., client) 130. The description will further assume by way of example that the digital data stream, or payload, has been divided into a sequence of frames or payload packets. According to the embodiment of the present invention, the video encoder (source node) 110 includes a video frame source 112, a video encoder including a base layer encoder 114a and an enhancement layer encoder 114b and an encoder buffer 116. Video frame source 112 may be any device capable of generating a sequence of uncompressed video frames, including a television antenna and receiver unit, a video cassette player, a video camera, a disk storage device capable of storing a "raw" video clip, and the like. The uncompressed video frames, sourced from video frame source 112, enter video encoder 114 at a given picture rate (or "streaming rate") and are compressed according to any known compression algorithm or device, such as an MPEG-4 encoder. Video encoder 114 then transmits the compressed video frames to encoder buffer 116 for buffering in preparation for transmission across data network 120 via server 118. It is noted that video encoder 110 may be executing either external to or within a general purpose server 118.

Data network 120 may be any suitable network and may include portions of both public data networks, such as the Internet, and private data networks, such as an enterprise-owned local area network (LAN), metropolitan are network (MAN) or wide area network (WAN).

Depending on the application, destination node (client) 130, which receives the streaming media, may be embodied in many different ways, including a computer, a handheld entertainment device, a set-top box, a television, an Application Specific Integrated Circuits (ASIC), and so forth. Destination node (client) 130 includes a decoder buffer 132, a video decoder 134 and a video display 136.

FIG. 2 illustrates, by way of example, an architecture and associated protocols for implementing the protection scheme of the invention having ACTs 1-5 shows as A1-A5. ACT 1:

An FGS encoded mp4 file is shown at act 1 of Fig. 2. The .mp4 file may be encoded such as at the video encoder 112 (See Fig. 1) using FGS techniques wherein a portion of the video data is first used to produce a base layer (BL) 202. An Enhancement layer (EL) 204 is then generated using the motion compensated residual images. Motion compensated residual images are then generated from the video data and base layer (BL) 202 using a fine granular coding technique. As is well known in the art, FGS encoding represents one type of video scalability. Images coded with this type of scalability can be decoded progressively. In other words, the decoder can start decoding and displaying the image without the need for receiving all of the data used for coding that image. As more data is received, the quality of the decoded image is progressively enhanced until the complete information is received, decoded, and displayed.

In addition to generating the FGS base layer 202 and enhancement layer 204, in accordance with the principles of the invention, multiple protection data streams are generated, each being dynamically selectable by the client upon demand. There is shown separate and independent protection data streams, each associated with the .mp4 file. A first protection track (EP1) 206 may be constructed, for example, in accordance with the principles of FEC error protection. A second protection track (EP2) 208 may be constructed, for example, in accordance with the principles of retransmission error protection. A third protection track (EP3) 210 may be constructed, for example, in accordance with a hybrid scheme that incorporates features of FEC error protection and retransmission error protection. Each of the three protection schemes are dynamically selectable by a client upon demand.

### ACT 2:

The principles of multi-track hinting are taught in co-pending U.S. patent application Ser. No. 60/451,916 filed March 4, 2003, entitled "System and Method for transmitting scalable coded video over an IP network". In accordance with the principles of multi-track hinting taught therein, a preprocessing method, referred to as multi-track hinting, backward compatible with the current MPEG-4 media file format standard, makes it possible to use a general purpose MPEG-4 streaming server to efficiently stream layered video in accordance with changing channel characteristics, complexity constraints and user preferences. That is, the server, without major modification, is capable of automatically using multiple channels (i.e., RTP connections), thereby providing the streaming system the flexibility to adapt to network conditions (e.g., available bandwidth) by adjusting the number of scalable layers to be transmitted. As the available network bandwidth decreases, less hint tracks are required by the server because a smaller portion of the video stream is scalably transmitted to comply with the decreased bandwidth.

As shown in Fig. 2, a hinter module 214 generates a hint track (i.e., hint 1) 216a to facilitate the transmission of the FGS encoded base layer 202 across a data network such as, for example, data network 120. In addition, the hinter module 214 generates a plurality of hint tracks, i.e., (hint tracks 2 - 5) 216b-e, each being associated with enhancement layer (EL) 204.

One feature of the present invention is that each of the protection tracks, i.e., EP1, EP2 and EP3, may advantageously utilize the principles of multi-track hinting method to thereby provide error protection according to the prevailing network conditions. That is, multiple hint tracks may be used to stream the protection track via multiple RTP connections in much the same manner as is performed for the .mp4 parent data file, as described in co-pending application 60/451,916, referenced above. This flexibility in streaming the protection track across a network is illustrated by way of example in Fig. 2 where there is shown multiple hint tracks associated with each of the protection tracks, e.g., EP1-3. Specifically, for the first protection track EP1 206, the hinter 214 generates hint tracks 6 and 7, designated as 216f and 216g. For protection track EP2 208, the hinter 214 generates hint tracks 8, 9 and 10, designated respectively as 216h, 216i and 216j. Associated with protection track EP3 210, the hinter 214 generates a single hint track 11, 216k.

In the present context, the teachings of co-pending application 60/451,916, referenced above, remain true, however, in addition, hint tracks are utilized to transmit protection tracks to protect data streams being transmitted across a network. Specifically, the protection data streams may be scalably transmitted across the network in compliance with a measured network condition. However, the network condition of note in the present context is not the bandwidth, as is true of the video data stream, but rather the measured packet loss rate. As the packet loss rate is determined to be increasing there is a need or increased error protection. Accordingly, additional hint tracks above the number initially used to facilitate the transmission of the protection data streams will be utilized to compensate for the measured increase in the packet loss rate.

As a specific example, reference is made to exemplary protection track EP2 208, which has associated with it three hint tracks 8-10, 216h-j, which were generated simultaneous with EP2 208. Assuming that the initially measured packet loss rate is such that only a subset of the three hint tracks are initially required to facilitate the scalable portion of protection data stream EP2 208 necessary to satisfy a predetermined packet loss threshold, e.g., hint track 8 216h. Assume now that the packet loss rate increases at some point. It may then be required to utilize one or more additional hint tracks associated with protection data stream EP2 208 to compensate for the degraded network condition (i.e., increase in packet loss rate). For example, it may be required at some point to utilize all three hint tracks 8-10 216h-j to thereby provide the highest scalable portion of protection data stream EP2 208.

The above description is provided to illustrate one feature of the invention. That being, the novel protection data streams may be scalably transmitted across the network in the same manner as the parent video data stream with the distinction being the parent video stream is scalably modified in accordance with a measured change in network bandwidth while the protection data streams are scalably modified in accordance with the measured change in packet loss rate. In the former case, when the bandwidth is decreased, less hint tracks are required. Similarly, and in the latter case, when the packet loss rate is decreased, less hint tracks are required.

### ACT 3:

In accordance with the principles of the invention, the client 130 may, at any point in time, dynamically subscribe or unsubscribe to receive a protection channel. Accordingly, the client 130 needs to monitor its receiving quality and actively trigger the protection channel when it deems necessary. To initiate error protection in accordance with the method of the invention, a client must first be made aware of the type of error protection available at the server. As such, a mechanism is required to inform clients of the availability and description of the types of error protection that are available from the server. This mechanism is preferably executed by initially performing a Session Description Protocol (SDP) between the client and server.

Generally, SDP is a protocol intended for describing multimedia sessions for the purposes of session announcement, session invitation, and other forms of multimedia session initiation. It is also maintained by the IETF, and further information regarding SDP is located on the Internet at www.ietf.org in general, and at www.ietf.org/rfc/rfc2327.txt in particular. The present invention extends the functionality of SDP to include protocols which convey additional information to the client concerning the availability and characteristics of error protection available from the server.

In operation, the SDP protocol is performed between client and server prior to making a subscription request for a video data file, e.g., an .mp4 file. The SDP protocol session avails the client of various information about the session. Most importantly, the client is made aware of what options are available regarding error protection. Namely, the types of error protection available, the track numbers and so on. The client stores this information which may then be later used if the client should at some point during the transmission of the video source file, determine that error protection is warranted.

In the event the client makes a determination that error protection is warranted, the client requests error protection by first making a subscription request to the server using the RTSP protocol. As described above, the RTSP protocol is an application-level protocol, which offers a session negotiation and content description mechanism. That is, the RTSP protocol describes how to stream content from a server to a client. The request is transmitted across the IP network 120 using a common IP based packet switching technology such as the Transmission Control Protocol (TCP). As is well known in the art, the TCP protocol is a network protocol system that is independent of computer or network operating system and architectural differences. Assuming there is no pre-existing communication channel between the client and the server, a server receives a client subscription request. An exemplary client subscription request may have the following form:
Client → Server
1. SET_PARAMETER rtsp://130.140.67.83/sample.mp4 RTSP/1.0
2. CSeq:32
3. Session: 3453643
4. Content-length: 35
5. Content-type: text/bool/integer
6. Track 11: 1 . //the 11^{th} track is set to be 1 (ACTIVE)
7. Range: 34521- 34570 // 50 packets are required, (start seq. #
- end seq. #) //

Of particular note in the subscription request above, are lines 6 and 7. Specifically, the client has made a subscription request to activate protection track 11 for the range of packets denoted by packet identifiers 34521 - 34570. That is, the client has made a determination that the specific range of packets specified has been corrupted or dropped and wishes to retrieve them via protection channel 11. Protection channel 11 may be synonymous with any number of error protection schemes provided by the server including FEC error protection, retransmission error protection, or a hybrid scheme.

With continued reference to FIG. 2, protection channel 11 may be synonymous with protection track EP1 or EP2 or EP3, for example.

In response to the client based subscription request, the server may respond to the client with an acknowledgment which may have the following form:
Server → Client
1. RTSP/1.0 200OK
2. CSeq:32
3. Date: 28 Jan 2002 15:33:10 GMT

As emphasized in line 6 of the subscription request above, it should be noted that one feature of the present invention, is the flexibility provided in allowing a client to dynamically select one protection scheme from among a plurality of error protection choices available from the server. This flexibility stands in contrast to prior art approaches which restrict a client to select only a single unchangeable method of error protection, e.g., either retransmission or FEC protection. Advantageously, by maintaining the protection channel(s) as separate distinct data streams apart from the corresponding data stream, multiple error protection options are made available to the client upon demand. Further, by separating protection data from protected data, changing the protection data can change the protection level or strategy, but the protection procedures remain the same.

Next, it will be described in more detail how a client selects a protection scheme from among the protection schemes made available at the server.

In accordance with one embodiment, a protection scheme may be selected by the client via the range parameter (See line 7 above, i.e., Range: 34521 - 34570). That is, whenever the end sequence number in the range, e.g., 34570, is specified to be infinity as part of the request, the server may assume that the client desires an FEC type error protection mode, for example. Alternatively, whenever the end sequence number is equal to the starting sequence number + 1, it may be assumed that the client desires a retransmission type protection mode. If neither of these two options are selected, it is assumed that the client desires a hybrid transmission mode (e.g., a combination of FEC and retransmission), as indicated in the example above (i.e., end sequence number > 1 + starting sequence number and not equal to infinity).

Other modes of selecting a protection scheme, not explicitly recited herein, are also within the contemplation of the invention.

With continued reference to Fig. 2, subsequent to sending the acknowledgment in response to the client subscription request, the server loads the appropriate hint tracks and creates an RTP connection for each hint track. In the example shown, RTP connection 218a is created for hint track 1, 216a, RTP connections 218b-e are created for hint tracks 216b-e, respectively. Assume, for purposes of explanation that protection track EP1 is selected by the client 130, in this case hint tracks 6 and 7, 216f and 216g, respectively are loaded and RTP connections 218f and 218g are created. It is to be appreciated that additional dedicated RTP connections, e.g., 218f and 218g, are created to facilitate the transfer of protection data.

### ACT 4:

At act 4, the client 130 creates a corresponding RTP connection to those described above at act 3 to facilitate the transfer of the video data and corresponding protection track data.

### ACT 5:

At act 5, the transmitted FGS encoded video data streams, i.e., BL 202 and EL 204 are decoded and displayed.

The foregoing descriptions of specific embodiments of the present invention have been presented for purposes of illustration and description. They are not intended to be exhaustive or to limit the invention to the precise forms disclosed, and obviously many modifications and variations are possible in light of the above teaching. The embodiments were chosen and described in order to best explain the principles of the invention and its practical application, to thereby enable others skilled in the art to best utilize the invention and various embodiments with various modifications as are suited to the particular use contemplated. It is intended that the scope of the invention be defined by the Claims appended hereto.

## Claims

1. A method of transmitting a bit stream (202, 204) across a network (120) from a sending device (114) to a receiving device (130), the method comprising:
- a coding act for producing at least one protection bit stream (206) from said bit stream (202, 204) using a channel coding technique and for producing at least one further protection bit stream (208) from said bit stream (202, 204) using a further channel coding technique;
**characterised in that** the method further comprises
- a generating act for generating at least one hint track (216f, 216g) from said protection bit stream (206) and for generating at least two further hint tracks (216h, 216i, 216j) from said further protection bit stream (208), wherein said at least one hint track (216f, 216g) is associated with said at least one protection bit stream (206) in a many-to-one relationship and
wherein said at least two further hint tracks (216h, 216i, 216j) are associated with said at least one further protection bit stream (208) in a many-to-one relationship.

2. The method of Claim 1 further comprising a storing act for storing said at least one protection bit stream (206) and said at least one further protection bit stream (208) and said at least one hint track (216f, 216g) and said at least two further hint tracks (216h, 216i, 216j) on a storage medium.

3. The method of Claim 1 further comprising the acts of:
- receiving from said receiving device (130) an error correction request for error protection; and
- outputting a first protection bit stream (206) from among said protection bit streams (206, 208) in accordance with associated hint tracks (216f, 216g) from among said hint tracks (216f - 216j);
wherein said first protection bit stream (206) is produced at said coding act and said associated hint tracks (216f, 216g) are generated at said generating act.

4. The method of Claim 3, further comprising the acts of:
- subsequently receiving from said receiving device (130) a modified error correction request for error protection in response to a change of network condition; and
- outputting at least one modified protection bit stream (208) from among said protection bit streams (206, 208) produced at said coding act in accordance with associated hint tracks (216h - 216j);
wherein said at least one modified protection bit stream (208) is produced at said coding act and said associated hint tracks (216h - 216j) are generated at said generating act.

5. The method of claim 1, wherein said bit stream (202, 204) is a data stream output in accordance with a source coding method.

6. The method of claim 1, wherein said protection bit streams (206, 208) are data streams produced in accordance with data protection coding methods.

7. The method of claim 1, wherein said hint tracks (216h - 216j) are data streams generated in accordance with hinting algorithms.

8. The method of claim 7, wherein said hinting algorithms are optimized in accordance with at least a network condition, network protocol and network type.

9. The method of Claim 1, wherein the receiving device (130) is a client device and the sending device (114) is a server device.

10. A computer-readable medium bearing instructions for performing error protection, said instructions being arranged, upon execution by one or more processors, to perform the acts of the method of claim 1.

11. An error protection system for transmitting a bit stream (202, 204) across a network (120) from a sending device (114) to a receiving device (130) and comprising:
- means for producing at least one protection bit stream (206) from said bit stream (202, 204) using a channel coding technique and for producing at least one further protection bit stream (208) from said bit stream (202, 204) using a further channel coding technique;
**characterised in that** the error protection system further comprises
- means for generating at least one hint track (216f, 216g) from said at least one protection bit stream (206) and for generating at least two further hint tracks (216h, 216i, 216j) from said further protection bit stream (208), wherein said at least one hint track (216f, 216g) is associated with said at least one protection bit stream (206) in a many-to-one relationship and
wherein said at least two further hint tracks (216h, 216i, 216j) are associated with said at least one further protection bit stream (208) in a many-to-one relationship.

12. The error protection system of claim 11, further comprising means for storing said at least one protection bit stream (206) and said at least one further protection bit stream (208) and said at least one hint track (216f, 216g) and said at least two further hint tracks (216h, 216i, 216j) on a storage medium.

13. The error protection system of claim 11, further comprising:
- means for receiving from said receiving device (130) an error correction request for error protection; and
- means for outputting a first protection bit stream (206) from among said protection bit streams (206, 208) in accordance with associated hint tracks (216f, 216g) from among said hint tracks (216f - 216j);
wherein said first protection bit stream (206) is produced at said coding act and said associated hint tracks (216f, 216g) are generated at said generating act.

14. The error correction system of claim 13, further comprising:
- means for subsequently receiving from said receiving device (130) a modified error correction request for error protection in response to a change of network condition; and
- means for outputting at least one modified protection bit stream (208) from among said protection bit streams (206, 208) produced at said coding act in accordance with associated hint tracks (216h - 216j);
wherein said modified protection bit stream (208) is produced at said coding act and said associated hint tracks (216h - 216j) are generated at said generating act.

15. The error correction system of claim 11, wherein said bit stream (202, 204) is a data stream output in accordance with a source coding method.

16. The error correction system of claim 11, wherein said protection bit streams (206, 208) are data streams produced in accordance with data protection coding methods.

17. The error correction system of claim 11, wherein said hint tracks (216h - 216j) are data streams generated in accordance with hinting algorithms.

18. The error correction system of claim 17, wherein said hinting algorithms are optimized in accordance with at least a network condition, network protocol and network type.

19. The error correction system of claim 11, wherein the receiving device (130) is a client device and the sending device (114) is a server device.

## Patentansprüche

1. Verfahren zum Übertragen eines Bitstroms (202, 204) über ein Netzwerk (120) von einer sendenden Anordnung (114) zu einer empfangenden Anordnung (130),
wobei das Verfahren die nachfolgenden Verfahrensschritte umfasst:
- einen Codierungsvorgang zum Erzeugen wenigstens eines Schutzbitstroms (206) aus dem genannten Bitstrom (202, 204) unter Anwendung einer Kanalcodierungstechnik und zum Erzeugen wenigstens eines weiteren Schutzbitstroms (208) aus dem genannten Bitstrom (202, 204) unter Anwendung einer weiteren Kanalcodierungstechnik;
**dadurch gekennzeichnet, dass** das Verfahren weiterhin Folgendes umfasst:
- einen Erzeugungsvorgang zum Erzeugen wenigstens einer Andeutungsspur (216f, 216g) aus dem genannten Schutzbitstrom (206) und zum Erzeugen wenigstens zweier weiterer Andeutungsspuren (216h, 216i, 216j) aus dem genannten weiteren Schutzbitstrom (208),
wobei die genannte wenigstens eine Andeutungsspur (216f, 216g) mit dem genannten wenigstens einen Schutzbitstrom (206) in einem Viele-zu-Einem-Verhältnis und wobei die genannten wenigstens zwei weiteren Andeutungsspuren (216h, 216i, 216j) mit dem genannten wenigstens einen weiteren Schutzbitstrom (208) in einem Viele-zu-Einem-Verhältnis.

2. Verfahren nach Anspruch 1, das weiterhin einen Speichervorgang umfasst zum Speichern wenigstens eines Schutzbitstroms (206) und des genannten wenigstens einen weiteren Schutzbitstroms (208) und der genannten wenigstens einen Andeutungsspur (216f, 216g) und der genannten wenigstens zwei weiteren Andeutungsspuren (216h, 216i, 216j) auf einem Speichermedium.

3. Verfahren nach Anspruch 1, das weiterhin die nachfolgenden Verfahrensschritte umfasst:
- das Empfangen eines Fehlerkorrekturantrags für Fehlerschutz von der genannten empfangenden Anordnung; und
- das Liefern eines ersten Schutzbitstroms (206) aus den genannten Schutzbitströmen (206, 208) entsprechend assoziierten Andeutungsspuren (216f, 216g) aus den genannten Andeutungsspuren (216f-216j);
wobei der genannte erste Schutzstrom (206) in dem genannten Codiervorgang erzeugt wird und die genannten assoziierten Andeutungsspuren (216f, 216g) in dem genannten Erzeugungsvorgang erzeugt werden.

4. Verfahren nach Anspruch 3, das weiterhin Folgendes umfasst:
- im Wesentlichen das Empfangen eines modifizierten Fehlerkorrekturantrags zum Fehlerschutz von der genannten empfangenden Anordnung (130) in Reaktion auf eine Änderung des Netzwerkzustandes, und
- das Liefern wenigstens eines modifizierten Schutzbitstroms (208) von den genannten Schutzbitströmen (206, 208), die in dem genannten Codiervorgang entsprechend assoziierten Andeutungsspuren (216h - 216j) erzeugt worden sind;
wobei der genannte wenigstens eine modifizierte Schutzbitstrom (208) in dem genannten Codiervorgang erzeugt wird und die genannten assoziierten Andeutungsspuren (216h - 216j) in dem genannten Erzeugungsvorgang erzeugt werden.

5. Verfahren nach Anspruch 1, wobei der genannte Bitstrom (202, 204) ein Datenstromausgang entsprechend einem Quellencodierverfahren ist.

6. Verfahren nach Anspruch 1, wobei die genannten Schutzbitströme (206, 208) Datenströme sind, die entsprechend Datenschutzcodierverfahren erzeugt sind.

7. Verfahren nach Anspruch 1, wobei die genannten Andeutungsspuren (216h - 216j) Datenströme sind, die entsprechend Andeutungsalgorithmen erzeugt worden sind.

8. Verfahren nach Anspruch 7, wobei die genannten Andeutungsalgorithmen entsprechend wenigstens dem Netzwerkzustand, dem Netzwerkprotokoll oder dem Netzwerktyp optimiert werden.

9. Verfahren nach Anspruch 1, wobei die empfangende Anordnung (130) eine Kundenanordnung ist und die sendende Anordnung (114) eine Serveranordnung ist.

10. Vom Computer lesbares Medium mit Instruktion zum Durchführen von Fehlerschutz, wobei die genannten Instruktionen dazu vorgesehen sind, um bei Durchführung durch einen oder mehrere Prozessoren, die Vorgänge des Verfahrens nach Anspruch 1 durchzuführen.

11. Fehlerschutzsystem zum Übertragen eines Bitstroms (202, 204) über ein Netzwerk (120) von einer sendenden Anordnung (114) zu einer empfangenden Anordnung (130), das die nachfolgenden Elemente umfasst:
- Mittel zum Erzeugen wenigstens eines Schutzbitstroms (206) aus dem genannten Bitstrom (202, 204) unter Anwendung einer Kanalcodiertechnik und zum Erzeugen wenigstens eines weiteren Schutzbitstroms (208) aus dem genannten Bitstrom (202, 204) unter Anwendung einer weiteren Kanalcodiertechnik;
**dadurch gekennzeichnet, dass** das Fehlerschutzsystem weiterhin Folgendes umfasst:
- Mittel zum Erzeugen wenigstens einer Andeutungsspur (216f, 216g) aus dem genannten wenigstens einen Schutzbitstrom (206) und zum Erzeugen wenigstens zweiter weiterer Andeutungsbitströme (216h, 216i, 216j) aus dem genannten weiteren Schutzbitstrom (208),
wobei die genannte wenigstens eine Andeutungsspur (216f, 216g) mit dem genannten wenigstens einen Schutzbitstrom (206) in einem Viele-zu-Einem-Verhältnis assoziiert ist und wobei die genannten wenigstens zwei weiteren Andeutungsspuren (216h, 216i, 216j) mit dem genannten wenigstens einen weiteren Schutzbitstrom (208) in einem Viele-zu-Einem-Verhältnis assoziiert sind.

12. Fehlerschutzsystem nach Anspruch 11, das weiterhin Mittel aufweist zum Speichern des genannten wenigstens einen Schutzbitstroms (206) und des genannten wenigstens einen weiteren Schutzbitstroms (208) und der genannten wenigstens einen Andeutungsspur (216f, 216g) und der genannten wenigstens zwei weiteren Andeutungsspuren (216h, 216i, 216j) auf einem Speichermedium.

13. Fehlerschutzsystem nach Anspruch 11, das weiterhin Folgendes umfasst:
- Mittel zum Empfangen eines Fehlerschutzantrags für Fehlerschutz von der genannten empfangenden Anordnung (130); und
- Mittel zum Liefern eines ersten Schutzbitstroms (206) von den genannten Schutzbitströmen (206, 208) entsprechend assoziierten Andeutungsspuren (216f, 216g) von den genannten Andeutungsspuren (216f- 216j);
wobei der genannte erste Schutzbitstrom in dem genannten Codiervorgang erzeugt wird, und die genannten assoziierten Andeutungsspuren (216f, 216g) in dem genannten Erzeugungsvorgang erzeugt werden.

14. Fehlerkorrektursystem nach Anspruch 13, das weiterhin Folgendes umfasst:
- Mittel zum nacheinander Empfangen eines modifizierten Fehlerkorrekturantrags für Fehlerschutz von der genannten empfangenden Anordnung (130), in Reaktion auf eine Änderung des Netzwerkzustandes; und
- Mittel zum Liefern wenigstens eines modifizierten Schutzbitstroms (208) von den genannten Schutzbitströmen (206, 208), die in dem genannten Codiervorgang entsprechend assoziierten Andeutungsspuren (216h - 216j) erzeugt worden sind;
wobei der genannte modifizierte Schutzbitstrom (208) in dem genannten Codiervorgang erzeugt wird und die genannten assoziierten Andeutungsspuren (216h -216j) in dem genannten Erzeugungsvorgang erzeugt werden.

15. Fehlerkorrektursystem nach Anspruch 11, wobei der genannte Bitstrom (202, 204) ein Datenstromausgang entsprechend einem Quellencodierverfahren.

16. Fehlerkorrektursystem nach Anspruch 11, wobei die genanten Schutzbitströme (206, 208) Datenströme sind, die entsprechend den Datenschutzcodierverfahren erzeugt worden sind.

17. Fehlerkorrektursystem nach Anspruch 11, wobei die genannten Andeutungsspuren (216h - 216j) Datenströme sind, die entsprechend Andeutungsalgorithmen erzeugt worden sind.

18. Fehlerkorrektursystem nach Anspruch 17, wobei die genannten Andeutungsalgorithmen entsprechend wenigstens einem Netzwerkzustand, einem Netzwerkprotokoll oder einem Netzwerktyp optimiert werden.

19. Fehlerkorrektursystem nach Anspruch 11, wobei die empfangende Anordnung (130) eine Kundenanordnung, und die sendende Anordnung (114) eine Serveranordnung ist.

## Revendications

1. Procédé de transmission d'un train de bits (202, 204) à travers un réseau (120) depuis un dispositif émetteur (114) vers un dispositif récepteur (130), le procédé comprenant :
- un acte de codage pour produire au moins un train de bits de protection (206) à partir dudit train de bits (202, 204) en utilisant une technique de codage de canal et pour produire au moins un autre train de bits de protection (208) à partir dudit train de bits (202, 204) en utilisant une autre technique de codage de canal;
**caractérisé en ce que** le procédé comprend en outre
- un acte de génération pour générer au moins une piste d'optimisation (216f, 216g) à partir dudit train de bits de protection (206) et pour générer au moins deux autres pistes d'optimisation (216h, 216i, 216j) à partir dudit autre train de bits de protection (208), dans lequel ladite au moins une piste d'optimisation (216f, 216g) est associée audit au moins un train de bits de protection (206) dans une relation de plusieurs à un et dans lequel lesdites au moins deux autres pistes d'optimisation (216h, 216i, 216j) sont associées audit au moins un autre train de bits de protection (208) dans une relation de plusieurs à un.

2. Procédé suivant la revendication 1, comprenant en outre un acte de stockage pour stocker ledit au moins un train de bits de protection (206) et ledit au moins un autre train de bits de protection (208) et ladite au moins une piste d'optimisation (216f, 216g) et lesdites au moins deux autres pistes d'optimisation (216h, 216i, 216j) sur un support de stockage.

3. Procédé suivant la revendication 1 comprenant en outre les actes suivants :
- réception dudit dispositif récepteur (130) d'une demande de correction d'erreurs pour une protection contre les erreurs; et
- sortie d'un premier train de bits de protection (206) de parmi lesdits trains de bits de protection (206, 208) suivant des pistes d'optimisation associées (216f, 216g) de parmi lesdites pistes d'optimisation (216f - 216j);
dans lequel ledit premier train de bits de protection (206) est produit au moment dudit acte de codage et lesdites pistes d'optimisation associées (216f, 216g) sont générées au moment dudit acte de génération.

4. Procédé suivant la revendication 3, comprenant en outre les actes suivants :
- réception ultérieure à partir dudit dispositif récepteur (130) d'une demande de correction d'erreur modifiée en vue d'une protection contre les erreurs en réponse à une modification de l'état du réseau; et
- sortie d'au moins un train de bits de protection modifié (208) de parmi lesdits trains de bits de protection (206, 208) produits au moment dudit acte de codage conformément à des pistes d'optimisation associées (216h - 216j);
dans lequel ledit au moins un train de bits de protection modifié (208) est produit au moment dudit acte de codage et lesdites pistes d'optimisation associées (216h - 216j) sont générées au moment dudit acte de génération.

5. Procédé suivant la revendication 1, dans lequel ledit train de bits (202, 204) est un train de données sorti conformément à un procédé de codage de source.

6. Procédé suivant la revendication 1, dans lequel lesdits trains de bits de protection (206, 208) sont des trains de données produits conformément à des procédés de codage de protection de données.

7. Procédé suivant la revendication 1, dans lequel lesdites pistes d'optimisation (216h - 216j) sont des trains de données générés conformément à des algorithmes d'optimisation.

8. Procédé suivant la revendication 7, dans lequel lesdits algorithmes d'optimisation sont optimisés conformément à au moins un état de réseau, un protocole de réseau et un type de réseau.

9. Procédé suivant la revendication 1, dans lequel le dispositif récepteur (130) est un dispositif de client et le dispositif émetteur (114) est un dispositif serveur.

10. Support lisible par ordinateur portant des instructions pour assurer la protection contre les erreurs, lesdites instructions étant agencées, lors d'une exécution par un ou plusieurs processeurs, pour mettre en application les actes du procédé de la revendication 1.

11. Système de protection contre les erreurs pour la transmission d'un train de bits (202, 204) à travers un réseau (120) depuis un dispositif émetteur (114) vers un dispositif récepteur (130) et comprenant :
- un moyen pour produire au moins un train de bits de protection (206) à partir dudit train de bits (202, 204) en utilisant une technique de codage de canal et pour produire au moins un autre train de bits de protection (208) à partir dudit train de bits (202, 204) en utilisant une autre technique de codage de canal;
**caractérisé en ce que** le système de protection contre les erreurs comprend en outre
- un moyen pour générer au moins une piste d'optimisation (216f, 216g) à partir dudit au moins un train de bits de protection (206) et pour générer au moins deux autres pistes d'optimisation (216h, 216i, 216j) à partir dudit autre train de bits de protection (208), dans lequel ladite au moins une piste d'optimisation (216f, 216g) est associée audit au moins un train de bits de protection (206) dans une relation de plusieurs à un et dans lequel lesdites au moins deux autres pistes d'optimisation (216h, 216i, 216j) sont associées audit au moins un autre train de bits de protection (208) dans une relation de plusieurs à un.

12. Système de protection contre les erreurs suivant la revendication 11, comprenant en outre un moyen pour stocker ledit au moins un train de bits de protection (206) et ledit au moins un autre train de bits de protection (208) et ladite au moins une piste d'optimisation (216f, 216g) et lesdites au moins deux autres pistes d'optimisation (216h, 216i, 216j) sur un support de stockage.

13. Système de protection contre les erreurs suivant la revendication 11, comprenant en outre :
- un moyen pour la réception à partir dudit dispositif récepteur (130) d'une demande de correction d'erreurs pour la protection contre les erreurs; et
- un moyen pour la sortie d'un premier train de bits de protection (206) de parmi lesdits trains de bits de protection (206, 208) suivant des pistes d'optimisation associées (216f, 216g) de parmi lesdites pistes d'optimisation (216f - 216j);
dans lequel ledit premier train de bits de protection (206) est produit au moment dudit acte de codage et lesdites pistes d'optimisation associées (216f, 216g) sont générées au moment dudit acte de génération.

14. Système de correction d'erreurs suivant la revendication 13, comprenant en outre :
- un moyen pour la réception ultérieure à partir dudit dispositif récepteur (130) d'une demande de correction d'erreur modifiée en vue de la protection contre les erreurs en réponse à une modification de l'état du réseau; et
- un moyen pour la sortie d'au moins un train de bits de protection modifié (208) de parmi lesdits trains de bits de protection (206, 208) produits au moment dudit acte de codage conformément à des pistes d'optimisation associées (216h - 216j);
dans lequel ledit train de bits de protection modifié (208) est produit au moment dudit acte de codage et lesdites pistes d'optimisation associées (216h - 216j) sont générées au moment dudit acte de génération.

15. Système de correction d'erreurs suivant la revendication 11, dans lequel ledit train de bits (202, 204) est un train de données sorti conformément à un procédé de codage de source.

16. Système de correction d'erreurs suivant la revendication 11, dans lequel lesdits trains de bits de protection (206, 208) sont des trains de données produits conformément à des procédés de codage de protection de données.

17. Système de correction d'erreurs suivant la revendication 11, dans lequel lesdites pistes d'optimisation (216h - 216j) sont des trains de données générés conformément à des algorithmes d'optimisation.

18. Système de correction d'erreurs suivant la revendication 17, dans lequel lesdits algorithmes d'optimisation sont optimisés conformément à au moins un état de réseau, un protocole de réseau et un type de réseau.

19. Système de correction d'erreurs suivant la revendication 11, dans lequel le dispositif récepteur (130) est un dispositif de client et le dispositif émetteur (114) est un dispositif serveur.
